Europäisches Patentamt

European Patent Office

Office européen des brevets

(11) Numéro de publication:

**0 020 235**
**A1**

## DEMANDE DE BREVET EUROPEEN

(21) Numéro de dépôt: **80400697.1**

(22) Date de dépôt: **20.05.80**

(51) Int. Cl.³: **H 03 G 11/02, H 01 P 1/15**

(30) Priorité: **31.05.79 FR 7913988**

(43) Date de publication de la demande: **10.12.80**
**Bulletin 80/25**

(84) Etats contractants désignés: **CH DE GB IT LI NL SE**

(71) Demandeur: **"THOMSON-CSF"- SCPI, 173, Boulevard Haussmann, F-75360 Paris Cedex 08 (FR)**

(72) Inventeur: **Martel, Jacques, "THOMSON-CSF" SCPI 173, Bld Haussmann, F-75360 Paris Cedex 08 (FR)**
Inventeur: **Sillard, Gilles, "THOMSON-CSF" SCPI 173, Bld Haussmann, F-75360 Paris Cedex 08 (FR)**

(74) Mandataire: **Eisenbeth, Jacques Pierre et al, "THOMSON-CSF" - SCPI 173, bld Haussmann, F-75360 Paris Cedex 08 (FR)**

(54) Limiteur passif d'ondes électromagnétiques et duplexeur constitué à l'aide d'un tel limiteur.

(57) Limiteur passif réalisé en guide d'onde, dans au moins une section droite du guide, par une ou plusieurs fenêtres résonnantes (1) dans laquelle est montée en shunt au moins tête-bêche une paire de diodes (9 et 10), de même polarité et placées dans le même plan.

Application aux duplexeurs constitués par un ou plusieurs limiteurs selon l'invention.

1

# LIMITEUR PASSIF D'ONDES ELECTROMAGNETIQUES ET DUPLEXEUR CONSTITUE A L'AIDE D'UN TEL LIMITEUR

L'invention est relative à un limiteur passif d'ondes électromagnétiques ainsi qu'à un duplexeur que l'on peut constituer à l'aide d'un tel limiteur.

Les limiteurs passifs sont généralement constitués par des diodes dont les performances reflètent celles que l'on peut attendre ensuite des dispositifs duplexeurs qui les comportent. Des précisions sont données dans "Radar Handbook" de M. SKOLNIK 1970 page 8.24.

De fait, les limiteurs passifs selon l'invention doivent pouvoir supporter des puissances crêtes hyperfréquences de l'ordre de plusieurs centaines de kilowatts.

Dans les équipements de détection électromagnétiques ou radars auxquels la présente invention s'applique plus particulièrement la protection du récepteur du radar contre les émissions de son propre émetteur ou d'émetteurs voisins à constitué un problème auquel on s'est attaché dès le début. De fait dans un radar les duplexeurs qui sont des limiteurs insérés dans la chaîne de réception entre deux jonctions 3 dB, ont pour rôle dans le cas où l'équipement fonctionne avec une seule antenne commune émission-réception de découpler fortement l'émetteur du récepteur de l'ordre au moins de 40 décibels.

On va rappeler de façon succincte le rôle et le fonctionnement d'un duplexeur dans un radar connecté à une seule antenne. Il est absolument nécessaire d'éviter que l'énergie à haut niveau transmise par l'émetteur à l'antenne n'atteigne le récepteur qu'elle

2

détruirait. Il en est de même de l'énergie à l'émission provenant d'un radar voisin de celui concerné. Réciproquement il est hautement souhaitable que toute l'énergie recueillie par l'antenne en provenance d'une cible éclairée par le rayonnement émis soit transmise sans perte au récepteur. Le duplexeur joue aussi le rôle d'un commutateur isolant le récepteur lors de l'émission ou d'une émission voisine puissante et ouvrant la voie lors de la réception.

La protection des récepteurs radar contre les puissances importantes de leur émetteur ou de celui des émetteurs voisins a d'abord été assurée par des tubes à gaz, appelés tubes TR qui, insérés dans la chaîne de réception avaient la structure d'un filtre passe-bande et la propriété d'être passants lorsque l'énergie hyperfréquence appliquée était faible et réfléchissants lorsque cette énergie dépassait quelques watts crête. Ces tubes (qui par ailleurs donnaient satisfaction) présentaient les inconvénients dus à une durée de vie limitée et un léger retard à l'allumage, laissant passer ainsi une partie de la puissance vers le récepteur qui finissait par se détériorer.

L'apparition des diodes P.I.N. a permis dans certains cas de remplacer ces tubes à gaz par des commutateurs plus fiables quant à la durée de vie. Cependant il est nécessaire d'associer à ces diodes PIN un circuit de commande pour les rendre conductrices un peu avant l'émission par une source de polarisation auxiliaire et pour leur appliquer une tension inverse afin de diminuer les pertes au moment de la réception. Ces circuits de commande étant synchrones avec l'émission radar, les commuta-

3

teurs à diodes PIN ne protègent toutefois pas le
récepteur radar contre les émetteurs voisins.

Enfin, l'utilisation de diodes spécialement
conçues et associées par paires a permis de réaliser
un dispositif de protection à l'état solide, entièrement passif et pouvant supporter des puissances d'une
dizaine de kilowatts crête. Cependant, malgré le
montage des diodes dans des boîtiers présentant une
céramique en un matériau bon conducteur de la
chaleur, tel que de l'oxyde de beryllium, l'échauffement provoqué par leurs pertes, bien que très
faibles, conduit à leur destruction lorsque la puissance d'émission devient trop grande. En effet les
diodes se trouvent dans une zone où le couplage est
maximum. Un autre inconvénient concernant l'utilisation de ces diodes pour des dispositifs en guide
d'onde de forte puissance et aux fréquences basses :
les dimensions des structures hyperfréquences sont
très importantes devant les dimensions des diodes,
rendant difficile l'optimisation des performances.

Le but de la présente invention est de réaliser des limiteurs passifs en guide d'onde exempts
des inconvénients précités et permettant de transporter une grande énergie avec des puissances crêtes
importantes, et de les grouper pour constituer des
duplexeurs.

Suivant l'invention, un limiteur est réalisé
en guide comportant au moins une fenêtre résonnante,
située dans une section droite, dans laquelle est
montée en shunt une paire de diodes tête-bêche, de
même polarité et placées dans un même plan.

On réalise ainsi des limiteurs constitués par
une ou plusieurs paires de diodes et des duplexeurs
en insérant ces limiteurs entre deux coupleurs à 3dB.

4

D'autres caractéristiques et avantages de l'invention apparaîtront dans la description qui suit, illustrée par les figures suivantes représentant :

- la figure 1, un limiteur selon l'invention, réalisé dans une section droite d'un guide ;

- les figures 2 à 5, des exemples de réalisation non limitatifs de limiteurs selon l'invention;

- les figures 6 et 7, deux vues de profil d'un limiteur selon l'invention ;

- la figure 8, un duplexeur suivant l'invention.

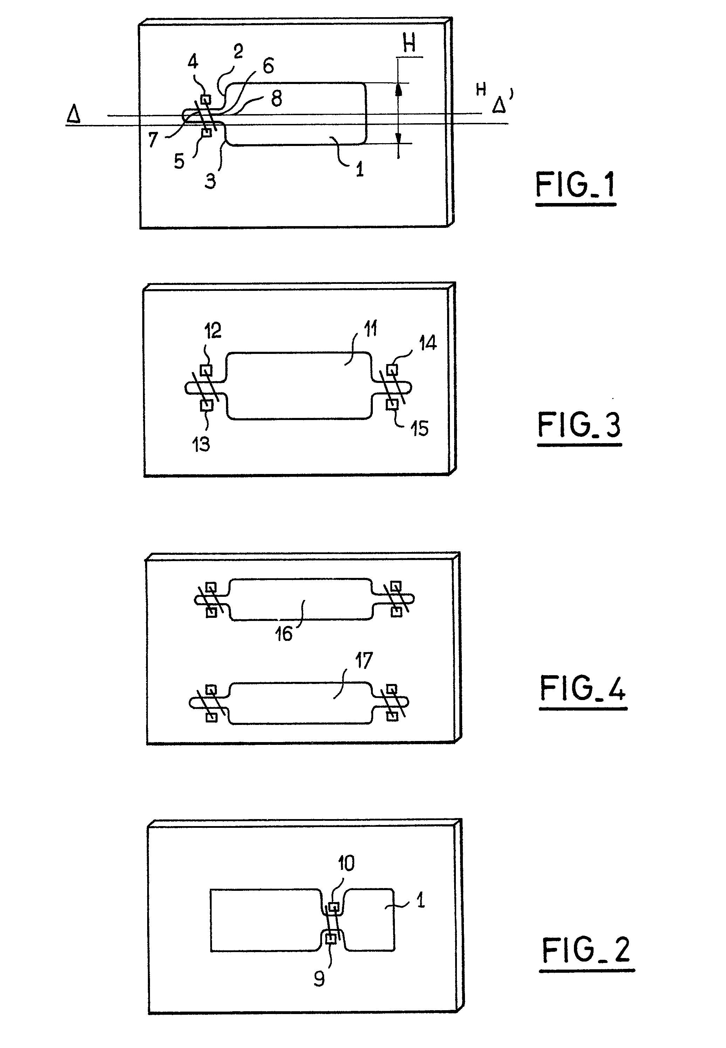

La figure 1 représente une vue de face d'une section droite du guide d'onde dans lequel est réalisé le limiteur selon l'invention. Ce limiteur est constitué par une ou plusieurs sections droites comportant chacune une ou plusieurs fenêtres résonnantes.

La section droite de la figure 1 comprend une fenêtre résonnante 1 d'axe $\Delta'$ parallèle à l'axe longitudinal $\Delta$ de la section dont les dimensions sont fonction de la puissance que le limiteur doit pouvoir supporter et de la limitation désirée. Sur chacun des deux bords 2 et 3 de la fenêtre 1 est placée une diode 4 ou 5, reliée à l'autre bord par un fil 6 ou 7 métallique de connexion. Les deux diodes 4 et 5 sont placées tête-bêche symétriquement par rapport à l'axe $\Delta'$ de la fenêtre 1, dans un même plan, ce qui permet d'utiliser des diodes de même polarité. Ce montage permet d'assurer une bonne dissipation thermique grâce à la masse métallique du dispositif, et une parfaite symétrie grâce à la polarité des diodes. Pour réduire l'inductance des fils de connexion 6 et 7, la hauteur 4 de la fenêtre 1 - ou dimension perpendiculaire de l'axe $\Delta'$ de la

fenêtre - est diminuée au niveau de l'emplacement des diodes, provoquant un rétrécissement 8 de la fenêtre 1. A bas niveau de puissance, les diodes 4 et 5 se comportent comme des capacités et l'ensemble constitué par la fenêtre 1 et les diodes 4 et 5 résonne à la fréquence désirée, laissant passer ainsi l'énergie hyperfréquence. Lorsque le niveau de puissance s'élève, une des diodes se comporte comme un court-circuit, et désaccorde le dispositif qui ne résonne plus à la fréquence désirée, assurant ainsi la limitation. Les diodes étant montées tête-bêche et dans le même plan, c'est soit l'une soit d'autre diode qui conduit selon la polarité du signal hyperfréquence, protégeant ainsi l'autre diode et assurant une bonne tenue en puissance.

Le dispositif suivant l'invention présente l'avantage de permettre le montage des diodes à n'importe quel endroit de la fenêtre, de sorte que l'on peut modifier aisément le couplage des diodes suivant la limitation et la tenue en puissance désirées.Le champ hyperfréquence étant nul aux extrémités de la fenêtre et maximum au centre, on place les diodes 9 et 10 aux extrémités de la fenêtre 1 ou vers le centre comme le montre la figure 2 suivant le couplage recherché.

Quand on veut augmenter la tenue en puissance du limiteur pour une même limitation, on réalise une fenêtre symétrique 11, comportant une paire de diodes 12 et 13, 14 et 15 à chaque extrémité, comme le montre la figure 3. Pour augmenter la largeur de la bande des fréquences de fonctionnement du limiteur on augmente le coefficient de surtension du dispositif, en réalisant deux ou plusieurs fenêtres 16 et 17, comme il est représenté sur la figure 4.

6

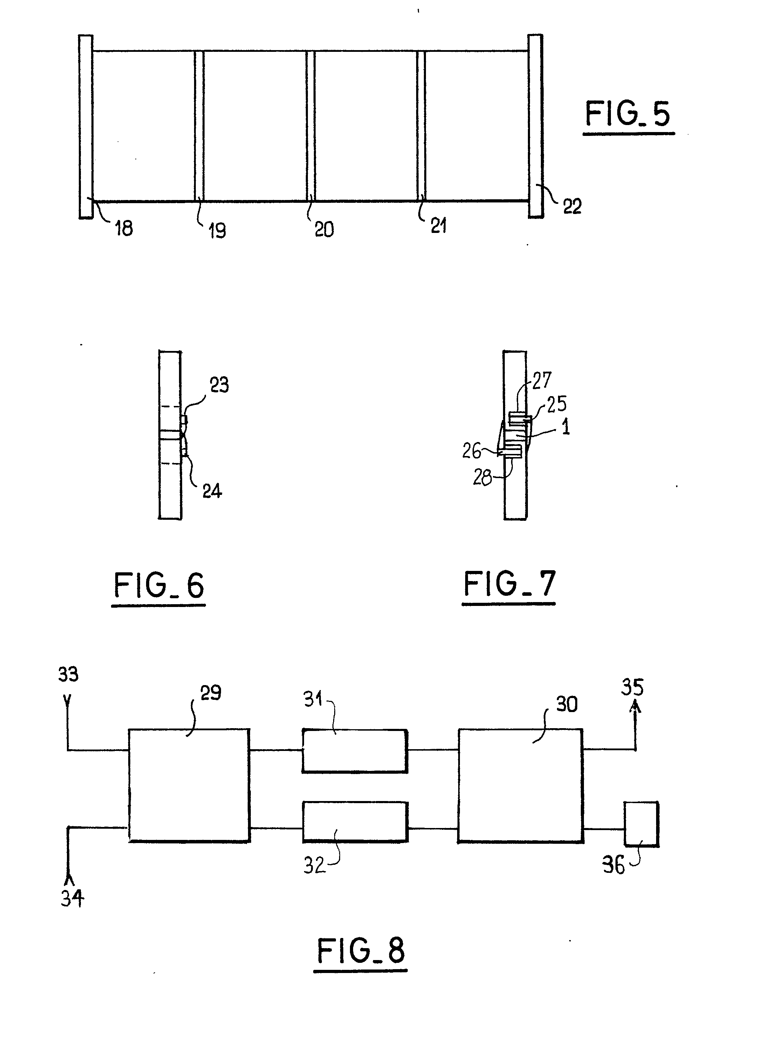

Le limiteur suivant l'invention peut aussi être constitué par plusieurs sections droites, 18 et 22 comme elles ont été décrites précédemment, qu'elles comportent une ou plusieurs fenêtres chacune. La figure 5 montre un tel limiteur, ayant une certaine répartition de coefficient de surtension et dont les différentes sections droites 18 et 22 sont espacées de manière à réaliser un filtre. L'expérience montre que l'on gagne 6 dB de limitation lorsque l'espacement entre chaque section est égal au quart de la longueur d'onde à la fréquence centrale de la bande de fonctionnement. Les diverses sections droites constituant le limiteur sont réparties de manière à ce que les diodes soient faiblement couplées, assurant une bonne tenue en puissance mais une faible limitation à l'entrée du limiteur et qu'elles soient de plus en plus couplées selon la puissance appliquée afin d'assurer une bonne limitation vers la sortie du limiteur.

Dans tous les types de limiteur selon l'invention qui viennent d'être décrits, les diodes 23 et 24 sans boîtier sont placées du même coté de la fenêtre 1, symétriquement par rapport à l'axe Δ' de la fenêtre, comme le montre la vue de profil d'une section droite, figure 6. Pour qu'elles soient en vis-à-vis par rapport à l'axe Δ', le fil de connexion qui les relie à l'autre bord est placé obliquement comme on le voit sur les figures 1 à 4. Les diodes peuvent également être placées dans un boîtier 25 et 26 pour qu'elles soient moins fragiles d'utilisation. Dans ce cas, un exemple de réalisation non limitatif est représenté figure 7. Deux trous 27 et 28 sont creusés dans la partie métallique entourant la fenêtre résonnante 1 de sorte que les diodes sont presque situées dans un même plan.

Comme il a été dit dans l'introduction, les limiteurs suivant l'invention qui viennent d'être décrits sont utilisables dans la réalisation de duplexeurs dont le rôle est important dans les équipements de détection électromagnétique ou radar. Le récepteur du radar doit être protégé à la fois contre les émissions à grande puissance de son propre émetteur et contre les émissions d'émetteurs voisins de celui concerné.

Généralement un duplexeur est constitué de deux limiteurs identiques insérés entre deux coupleurs 3 dB. La figure 8 représente le schéma d'un duplexeur constitué de deux coupleurs 3 dB 29 et 30 et de deux limiteurs 31 et 32 suivant l'invention.

L'entrée du coupleur 3 dB 29 est reliée d'une part à l'émetteur 33 et d'autre part à l'antenne émettrice-réceptrice 34, alors que ses deux sorties sont reliées respectivement aux deux limiteurs 31 et 32 selon l'invention. La sortie de chaque limiteur est reliée à l'entrée du coupleur 30 dont une sortie est reliée au récepteur 35 et dont l'autre sortie est reliée à une charge dissipatrice 36. A l'émission l'énergie à grande puissance émise par l'émetteur 33 passe dans le coupleur 29, se réfléchit sur les limiteurs 31 et 32 qui jouent le rôle d'interrupteur, grâce aux diodes qui deviennent équivalentes à des court-circuits, et est envoyée à travers le coupleur 29 à l'antenne 34. Les limiteurs évitent ainsi que toute la puissance émise par l'émetteur ne vienne endommager le récepteur. Inversement, à la réception, l'énergie beaucoup plus faible captée par l'antenne 34 passe dans les limiteurs 31 et 32 qui

8

sont passants pour l'énergie transmise à bas niveau. L'énergie est ensuite concentrée par le coupleur 30 avant d'aller au récepteur 35.

Suivant la puissance d'émission et suivant la la limitation désirée, les limiteurs 31 et32 sont réalisés comme les différentes figures 1 à 7 le montrent.

On a ainsi décrit dans ce qui précède des perfectionnements aux limiteurs passifs et aux duplexeurs comportant de tels limiteurs.

9

R E V E N D I C A T I O N S

1. Limiteur passif d'ondes électromagnétiques à semiconducteurs à faible capacité et à fréquence de coupure élevée, réalisé en guide d'onde, caractérisé en ce qu'il est réalisé dans au moins une section droite du guide par au moins une fenêtre résonnante dans laquelle est montée en shunt au moins une paire de diodes, de même polarité et placées dans un même plan.

2. Limiteur passif suivant la revendication 1, caractérisé en ce que les deux diodes (4 et 5) d'une paire sont montées chacune sur un des bords (2 ou 3) de la fenêtre, symétriquement par rapport à l'axe ($\Delta'$) de la fenêtre (1) parallèle à l'axe longitudinal ($\Delta$) de la section droite du guide, et sont reliées à l'autre bord par un fil (6 ou 7) métallique de connexion.

3. Limiteur passif suivant la revendication 2, caractérisé en ce que la hauteur (H) de la fenêtre (1) ou dimension perpendiculaire à l'axe longitudinal ($\Delta$) de la section droite, diminue à l'endroit des diodes (4 et 5) la fenêtre (1) présentant un rétrécissement, afin de réduire l'inductance des fils (6 et 7) de connexion.

4. Limiteur passif selon la revendication 3, caractérisé en ce qui le rétrécissement (8) de la fenêtre (1) se situe à une des extrémités de la fenêtre situées suivant l'axe ($\Delta'$) de la fenêtre, pour diminuer le couplage des diodes (4 et 5) placées au niveau du rétrécissement.

5. Limiteur passif selon la revendication 3, caractérisé en ce quele rétrécissement (8) de la fenêtre (1) se situe entre les deux extrémités de la fenêtre, le couplage des diodes placées au niveau de ce
rétrécissement étant maximum au centre de la fenêtre.

6. Limiteur passif selon la revendication 3, caractérisé en ce qu'aux deux extrémités de la fenêtre
(1) situées suivant son axe ($\Delta'$) se situent deux
rétrécissements, de part et d'autre de chacun
desquels est placée au moins une paire de diodes
(12 et 13) constituant ainsi une fenêtre symétrique
(11), ce qui permet une meilleure tenue en puissance.

7. Limiteur passif selon l'une des revendications 1
à 6, caractérisé en ce qu'il est constitué de plusieurs fenêtres (18 à 22) placées dans la même
section droite du guide, augmentant ainsi la largeur
de la bande de fonctionnement.

8. Limiteur passif, selon l'une des revendications 1
à 7, caractérisé en ce qu'il est constitué par
plusieurs sections droites du guide, comportant
chacune au moins une fenêtre résonnante.

9. Limiteur passif selon la revendication 8, caractérisé en ce que la distance entre plusieurs sections
droites du guide est égale au quart de la longeur
d'onde à la fréquence centrale de la bande de
fonctionnement.

10. Limiteur passif suivant l'une des revendications
1 à 9, caractérisé en ce que les deux diodes (23 et
24) d'une paire sont placées du même côté de la
fenêtre sur deux bords opposés, symétriquement par
rapport à l'axe ($\Delta'$) de la fenêtre.

11. Limiteur passif suivant la revendication 10,
caractérisé en ce que le fil de connexion reliant
chaque diode au bord de la fenêtre, opposé à celui
où elle est montée, est disposé obliquement permettant aux deux diodes d'être placées l'une en face de
l'autre.

11

12. Limiteur passif suivant l'une des revendications 1 à 9, caractérisé en ce que les deux diodes d'une paire sont montées chacune dans un boîtier (25 et 26), placés dans deux trous (27 et 28) réalisés de chaque côté de la fenêtre.

13. Duplexeur constitué par deux limiteurs passifs identiques, réalisés suivant l'une des revendications 1 à 12, et insérés entre deux coupleurs 3 dB (29 et 30)

0020235

FIG_1

FIG_3

FIG_4

FIG_2

FIG_5

18    19    20    21    22

FIG_6

23
24

FIG_7

27
25
1
26
28

33    29    31    30    35

32    36

34

FIG_8

| Catégorie | DOCUMENTS CONSIDERES COMME PERTINENTS | | CLASSEMENT DE LA DEMANDE (Int. Cl. 3) |
|---|---|---|---|
| | Citation du document avec indication, en cas de besoin, des parties pertinentes | Revendica-tion concernée | |
| | PROCEEDINGS OF THE IEEE, vol. 59, no. 8, août 1971 New York US K.E. MORTENSON et al.: "A review of bulk semiconductor microwave control components", pages 1191-1200 <br><br> * De page 1193, colonne de droite, point III - page 1198, colonne de gauche, point V; figures 2-10 * <br><br>-- | 1,13 | H 03 G 11/02 <br> H 01 P 1/15 |
| | FR - A - 2 260 879 (INTERNATIONAL STANDARD ELECTRIC) <br><br> * Figures 9,13,19,21; revendi-cations 1 et 4; page 4, lignes 20-31; page 5, lignes 12-32; de page 7, ligne 3 - page 8, ligne 4 * <br><br>-- | 1,8,9 | **DOMAINES TECHNIQUES RECHERCHES (Int. Cl. 3)** <br><br> H 03 G 11/02 <br> 11/00 <br> H 01 P 1/15 |
| | US - A - 4 155 054 (GOLDIE et al.) <br><br> * Figures 1-4; de colonne 1, ligne 57 - colonne 3, ligne 25 * <br><br>-- | 1,8,9 | |
| | FR - A - 1 168 674 (COMPAGNIE GENERALE DE TELEGRAPHIE SANS FIL) <br><br> * Figures 1-4; page 2, en entier * <br><br>-- | 1,5,7 | **CATEGORIE DES DOCUMENTS CITES** <br><br> X: particulièrement pertinent <br> A: arrière-plan technologique <br> O: divulgation non-écrite <br> P: document intercalaire <br> T: théorie ou principe à la base de l'invention |
| | US - A - 3 649 935 (LOW et al.) <br><br> * Figures 1 et 2; de colonne 1, ligne 42 - colonne 2, ligne 25 * <br><br>-- ./. | 1 | E: demande faisant interférence <br> D: document cité dans la demande <br> L: document cité pour d'autres raisons <br><br> &: membre de la même famille, document correspondant |

Le présent rapport de recherche a été établi pour toutes les revendications

| Lieu de la recherche | Date d'achèvement de la recherche | Examinateur |
|---|---|---|
| La Haye | 09-09-1980 | GYSEN |

OEB Form 1503.1   06.78

| | **DOCUMENTS CONSIDERES COMME PERTINENTS** | | **CLASSEMENT DE LA DEMANDE (Int. Cl. 3)** |
|---|---|---|---|
| Catégorie | Citation du document avec indication, en cas de besoin, des parties pertinentes | Revendica-tion concernée | |
| | 1967 INTERNATIONAL SOLID-STATE CIRCUITS CONFERENCE, session X, "Microwave Circuits, tenu 1e 17 février 1967 New York US K.E. MORTENSON: "X-band room-temperature bulk-effect, high-power limiter", pages 98-99  * Figures 1-4 *  -- | 1 | |
| | FR - A - 2 133 169 (THOMSON-CSF)  * Figures 12; page 11, lignes 5-12 *  ---- | 1,13 | **DOMAINES TECHNIQUES RECHERCHES (Int. Cl. 3)** |